(19) **Europäisches Patentamt**

**European Patent Office**

**Office européen des brevets**

(11) **EP 0 749 147 B1**

(12) **EUROPÄISCHE PATENTSCHRIFT**

(45) Veröffentlichungstag und Bekanntmachung des Hinweises auf die Patenterteilung:
**16.05.2001 Patentblatt 2001/20**

(51) Int Cl.⁷: **H01J 37/32**, C21D 1/09, C21D 1/38, C21D 9/00, C23C 8/36, H05B 7/00, H01J 37/34, H05H 1/36

(21) Anmeldenummer: **96106049.8**

(22) Anmeldetag: **18.04.1996**

(54) **Verfahren und Vorrichtung zur Steuerung der elektrischen Stromdichte über einem Werkstück bei der Wärmebehandlung im Plasma**

Method and device for controlling the electrical current density over a workpiece during heat treatment by plasma

Procédé et dispositif pour la commande de la densité de courant électrique sur une pièce soumise à un traitement thermique par plasma

(84) Benannte Vertragsstaaten:
**AT CH DE ES FR GB IT LI**

(30) Priorität: **13.06.1995 DE 19521548**

(43) Veröffentlichungstag der Anmeldung:
**18.12.1996 Patentblatt 1996/51**

(73) Patentinhaber: **Ipsen International GmbH**
**47533 Kleve (DE)**

(72) Erfinder:
• **Drissen, Hansjakob**
**47551 Bedburg-Hau (DE)**
• **Gräfen, Winfried**
**47198 Duisburg (DE)**
• **Edenhofer, Bernd, Dr.**
**47533 Kleve (DE)**

(74) Vertreter: **Stenger, Watzke & Ring Patentanwälte**
**Kaiser-Friedrich-Ring 70**
**40547 Düsseldorf (DE)**

(56) Entgegenhaltungen:
WO-A-91/10341     CH-A- 475 366
DE-A- 3 504 936     DE-A- 4 035 131
GB-A- 2 280 540     US-A- 5 292 370

• PATENT ABSTRACTS OF JAPAN vol. 095, no. 003, 28. April 1995 & JP 06 338481 A (TOSHIBA CORP), 6. Dezember 1994
• PATENT ABSTRACTS OF JAPAN vol. 018, no. 238 (E-1544), 6. Mai 1994 & JP 06 028991 A (RIKAGAKU KENKYUSHO;OTHERS: 01), 4. Februar 1994

**Beschreibung**

Die Erfindung betrifft ein Verfahren zur Steuerung der elektrischen Stromdichte über einem Werkstück bei der Wärmebehandlung im Plasma unter Verwendung einer Hilfselektrode mit bekannter Oberfläche $F_{HE}$. Ferner betrifft die Erfindung eine Vorrichtung zur Durchführung dieses Verfahrens.

Aus der CH-PS 4 75 366 ist eine Vorrichtung zur Überwachung des elektrischen Verhaltens einer Starkstrom-Glimmentladung bekannt. Bei dieser bekannten Vorrichtung werden die Speisespannung oder die gesamte Anlage abgeschaltet, wenn die Überwachung ergibt, daß die Glimmentladung in eine zu vermeidende, schädliche Bogenentladung umschlägt. Hierzu wird davon ausgegangen, daß solange das Verhältnis der Entladungsströme über das Werkstück und die Hilfselektrode gleich dem Verhältnis der Flächen des Werkstücks und der Hilfselektrode ist, keine Bogenentladung auftritt. Da bei dem Umschlagen der Glimmentladung in die Bogenentladung der betreffende Entladestrom ansteigt und sich somit das Strömeverhältnis ändert, nutzt diese bekannte Vorrichtung diese Änderung des Strömeverhältnisses aus, um durch Abschalten der Speisespannung bzw. der gesamten Anlage eine Bogenentladung zu unterbinden.

Bei einer Gas-Ionen- bzw. Plasma-Oberflächenbehandlung werden jedoch die sich ergebenden Oberflächeneigenschaften stark durch die Dichte des Entladungsstroms an der Oberfläche des Werkstücks bestimmt, so daß neben dem Schutz gegen eine ungleichmäßige Entladung bzw. eine Bogenentladung auch ein Messen und Steuern der elektrischen Stromdichte über das zu behandelnde Werkzeug notwendig ist. Während der Entladungsstrom über das Werkstück leicht zu messen und zu steuern ist, ist es schwierig, die Stromdichte über das Werkstück zu ermitteln, da zum Ermitteln der Stromdichte die Werkstückoberfläche zu ermitteln ist, an der der Entladungsstrom tatsächlich wirksam ist. Die Ermittlung der Chargenoberfläche ist insbesondere bei kompliziert geformten Teilen sehr aufwendig.

Aus der DE-PS 35 04 936 ist eine Vorrichtung zum Steuern des Entladestroms über ein Werkstück bekannt, bei der im Ofenraum neben der zu behandelnden Werkstückcharge eine Hilfselektrode angeordnet ist. Um nicht jedes Mal die Oberfläche der Charge ausrechnen oder ausmessen zu müssen, wird bei dieser bekannten Vorrichtung die Stromdichte im Ofen, also über der Werkstückcharge und der Hilfselektrode, gemessen und aus der bekannten Oberfläche der Hilfselektrode und dem separat gemessenen Strom durch die Hilfselektrode die Chargenoberfläche berechnet. Diese Messung der Gesamtstromdichte im Ofen wird kontinuierlich während des gesamten Plasmabeschichtungsprozesses fortgeführt. Bei dem Nachfahren der Versuche in der Praxis hat sich jedoch herausgestellt, daß sich entgegen der theoretischen Annahme der Entladestrom über die Charge während des Behandlungszyklusses ändert, obwohl die Hilfselektrode einen konstanten Strom regelt. Nachprüfungen haben ergeben, daß sich die Oberfläche der Hilfselektrode während des Plasmabeschichtungsprozesses verändert, was beispielsweise durch Rußabscheidungen geschehen kann. Diese Veränderungen der Chargenoberfläche kommen dadurch zustande, daß die Hilfselektrode während des gesamten Plasmabeschichtungsprozesses eingeschaltet bleiben muß, um die Gesamtstromdichte im Ofen zu messen.

Davon ausgehend liegt der Erfindung die **Aufgabe** zugrunde, ein Verfahren zur Steuerung der elektrischen Stromdichte über einem Werkstück zu schaffen, das eine einfache und reproduzierbare Steuerung dieser Stromdichte erlaubt. Ferner liegt der Erfindung die Aufgabe zugrunde, eine Vorrichtung zur Durchführung dieses Verfahrens zu schaffen.

Die verfahrensgemäße **Lösung** dieser Aufgabe durch die Erfindung ist gekennzeichnet durch die Verfahrensschritte:

a) Erzeugen eines Plasmas mit einem neutralen Gas;

b) Messen des Gesamtstroms $I_G$ im Ofen sowie des Stroms $I_{HE}$ durch die Hilfselektrode;

c) Berechnen der Chargenoberfläche $F_{CH}$ nach der Gleichung

$$F_{CH} = \frac{I_G}{I_{HE}} \cdot F_{HE} - F_{HE}$$

d) Abschalten der Hilfselektrode;

e) Erzeugen eines stoffübertragenden Plasmas;

f) Berechnen des einzustellenden Gesamtstroms $I_{Gsoll}$ zur Regelung des gewünschten Stromdichte-Sollwertes $J_{soll}$ nach der Gleichung:

$$I_{Gsoll} = F_{CH} \cdot J_{soll}$$

und

g) Messen des Gesamtstroms $I_G$ im Ofen und Einregeln von $I_G$ auf $I_{Gsoll}$.

Bei dem erfindungsgemäß ausgebildeten Verfahren wird die Hilfselektrode nur für einen kurzen Zeitraum und nur bei Vorliegen eines nicht stoffübertragenden Plasmas zur Messung des Gesamtstroms $I_G$ im Ofen mit Spannung beaufschlagt. Bei dem nachfolgenden Oberflächenbehandlungsprozeß im stoffübertragenden Plasma bleibt die Hilfselektrode im Gegensatz zum Verfahren gemäß der DE-PS 35 04 936 ausgeschaltet und erfährt deshalb auch keine Veränderung ihrer Oberfläche während des Plasmaprozesses. Bei diesem erfindungsgemäßen Verfahren ist es somit nach dem Berechnen der Chargenoberfläche $F_{CH}$ auch ohne zugeschaltete Hilfselektrode möglich, die Stromdichte nur durch Messen und Nachsteuern des Gesamtstroms $I_G$ im Ofen zu steuern.

Als Gase zur Erzeugung des neutralen, das heißt nicht stoffübertragenden Plasmas, werden gemäß einer bevorzugten Ausführungsform der Erfindung Argon, Neon, Helium oder Wasserstoff verwendet. Diese Gase zeichnen sich dadurch aus, daß das mit ihnen erzeugte Plasma keine Wechselwirkung mit den Oberflächen der Charge bzw. der Hilfselektrode eingeht und somit eine fehlerfreie und reproduzierbare Messung ermöglicht.

Zur Erzeugung des stoffübertragenden Plasmas werden gemäß einer bevorzugten Ausführungsform der Erfindung nitrierende, aufkohlende oder borierende Gase verwendet.

Die vorrichtungsmäßige **Lösung** ist erfindungsgemäß dadurch gekennzeichnet, daß der Gesamtstrom $I_G$ im Ofen über ein Strommeßgerät meßbar ist und zwischen das Strommeßgerät für den Gesamtstrom $I_G$ und die Hilfselektrode ein Strommeßgerät zum Messen des Stroms $I_{HE}$ über die Hilfselektrode sowie ein Schalter zum Abschalten der Hilfselektrode geschaltet sind.

Durch den zwischen Spannungsquelle und Hilfselektrode geschalteten Schalter ist es möglich, die Hilfselektrode nur kurzfristig, nämlich zur Messung des Gesamtstroms $I_G$ im neutralen Plasma mit Spannung zu versorgen. Anschließend wird über den Schalter die Hilfselektrode wieder abgeschaltet und somit gewährleistet, daß während des Plasmaprozesses keine Veränderungen der Oberfläche der Hilfselektrode stattfinden können.

Bei einer bevorzugten Ausführungsform der Erfindung ist das Strommeßgerät für den Gesamtstrom $I_G$ mit einem Regler gekoppelt, über den ein Abgleich des berechneten Wertes $I_{Gsoll}$ mit dem gemessenen Wert $I_G$ stattfinden kann. Weitere Einzelheiten und Vorteile ergeben sich aus der nachfolgenden Beschreibung der zugehörigen Zeichnung, in der ein Ausführungsbeispiel einer erfindungsgemäß ausgestalteten Vorrichtung zur Steuerung der elektrischen Stromdichte schematisch dargestellt ist.

Die dargestellte Vorrichtung besteht im wesentlichen aus einem Ofen 1 mit einer eine Ofenkammer 2 umgebenden abnehmbaren Ofenhaube 3 sowie einer Vakuumpumpe 4 zum Evakuieren der Ofenkammer 2 und einem Plasmagenerator 5 als Hochspannungsquelle zur Erzeugung des Plasmas in der Ofenkammer 2.

Zum Befüllen und Entleeren der Ofenkammer 2 kann die Ofenhaube 3, wie gestrichelt dargestellt, entlang von Führungsschienen 6 nach oben verfahren werden. In der Ofenkammer 2 sind ein Chargenträger 7 zur Aufnahme einer Werkstückcharge 8 sowie eine Hilfselektrode 9 angeordnet. Die als Plasmagenerator 5 dienende Hochspannungsquelle ist über eine Leitung 10 mit dem Chargenträger 7 verbunden. Von der Leitung 10 ist eine Leitung 11 abgezweigt, welche mit der Hilfselektrode 9 verbunden ist. In der Leitung 11 zur Hilfselektrode 9 sind ein Schalter 12 sowie ein Strommeßgerät 13 zum Messen des Stroms $I_{HE}$ durch die Hilfselektrode 9 angeordnet.

Zur Messung des Gesamtstroms $I_G$ im Ofen 1 ist, vom Plasmagenerator 5 aus gesehen, in die Leitung 10 vor der Abzweigung der Leitung 11 ein Strommeßgerät 14 zum Messen des Gesamtstroms $I_G$ im Ofen eingebaut. Um die mit dem Strommeßgerät 14 gemessene Stärke des Gesamtstroms $I_G$ auf den berechneten Gesamtstrom-Sollwert $I_{Gsoll}$ regeln zu können, ist das Strommeßgerät 14 mit einem Regler 15 verbunden.

Die Arbeitsweise der voranstehend beschriebenen Vorrichtung soll nachfolgend anhand eines Ausführungsbeispiels beschrieben werden:

### Ausführungsbeispiel

Eine Charge unbekannter Oberfläche, bestehend aus 672 kleinen Ritzeln, wurde in die Ofenkammer 2 des Ofen 1 chargiert. Daran anschließend wurde der Ofen 1 über die Vakuumpumpe 4 evakuiert und auf 850°C aufgeheizt. Die Temperatur wurde bis zum Temperaturausgleich über die gesamte Charge konstant gehalten. Nach Erreichen der konstanten Temperatur wurde der Ofen unter Wasserstoff-Gas gesetzt und auf einen Druck von 6 mbar geregelt. Nach Schließen des Schalters 12, das heißt nach dem Verbinden der Hilfselektrode 9 mit dem Plasmagenerator 5 über die Leitungen 10 und 11, wurde durch Anlegen einer Gleichspannung von 560 V mit dem in der Ofenkammer 2 befindlichen Wasserstoff-Gas ein neutrales, das heißt nicht stoffübertragendes Plasma erzeugt.

Am Strommeßgerät 14 konnte eine Gesamtstromstärke $I_G$ im Ofen 1 von 27000 mA gemessen werden. Gleichzeitig zeigte das Strommeßgerät 13 für den Strom $I_{HE}$ durch die Hilfselektrode 9 einen Wert von 91 mA an.

Unter Zugrundelegung dieser gemessenen Werte sowie der bekannten Oberfläche $F_{HE}$ der Hilfselektrode 9 von 577 cm$^2$. konnte nach der Gleichung

$$\frac{I_{HE}}{F_{HE}} = \frac{I_G}{F_{CH} + F_{HE}}$$

die unbekannte Chargenoberfläche $F_{CH}$ nach Umstellen der voranstehend genannten Gleichung wie folgt gelöst werden:

$$F_{CH} = \frac{I_G}{I_{HE}} \cdot F_{HE} - F_{HE}$$

Aufgrund der drei bekannten Werte, nämlich der gemessenen Stromstärken $I_G$ und $I_{HE}$ sowie der bekannten Oberfläche $F_{HE}$ der Hilfselektrode 9, ergab sich für die unbekannte Chargenoberfläche $F_{CH}$ ein Wert von 170620 cm$^2$.

Der bekannte Stromdichte-Sollwert $J_{soll}$ für den Plasmaprozeß betrug 0,65 mA/cm$^2$.

Nach dem Messen der Gesamtstromstärke $I_G$ im neutralen Plasma wurde der Schalter 12 geöffnet und somit die Hilfselektrode 9 vom Plasmagenerator 5 getrennt. Anschließend wurde die Werkstückcharge 8 auf die Endtemperatur geheizt und das Neutralgas-Plasma durch ein stoffübertragendes Plasma, nämlich ein aufkohlendes Plasma, ersetzt. Um den vorgegebenen Stromdichte-Sollwert $J_{soll}$ von 0,65 mA/cm$^2$ einregeln zu können, wurde dieser Wert mit der ermittelten Chargenfläche $F_{CH}$ multipliziert und daraus der Gesamtstrom $I_{Gsoll}$ als neue Regelgröße nach folgender Gleichung ermittelt:

$$I_{Gsoll} = J_{soll} \cdot F_{CH}$$

Diese Berechnung ergab für den über den Regler 15 am Strommeßgerät 14 einzustellenden Sollwert der Gesamtstromdichte $I_{Gsoll}$ einen Wert von 110903 mA.

Ein Nachrechnen der geometrischen Chargenoberfläche ergab einen Wert von 167758 cm$^2$, was bedeutet, daß der Meßfehler bei weniger als 2 % lag und somit das voranstehend beschriebene Verfahren ohne weiteres dazu geeignet ist, genaue und reproduzierbare Werte für die Steuerung der elektrischen Stromdichte bereitzustellen.

**Bezugszeichenliste**

1   Ofen

2   Ofenkammer

3   Ofenhaube

4   Vakuumpumpe

5   Plasmagenerator

6   Führungsschiene

7   Chargenträger

8   Werkstückcharge

9   Hilfselektrode

10   Leitung

11   Leitung

12   Schalter

13   Strommeßgerät ($I_{HE}$)

14   Strommeßgerät ($I_G$)

15   Regler

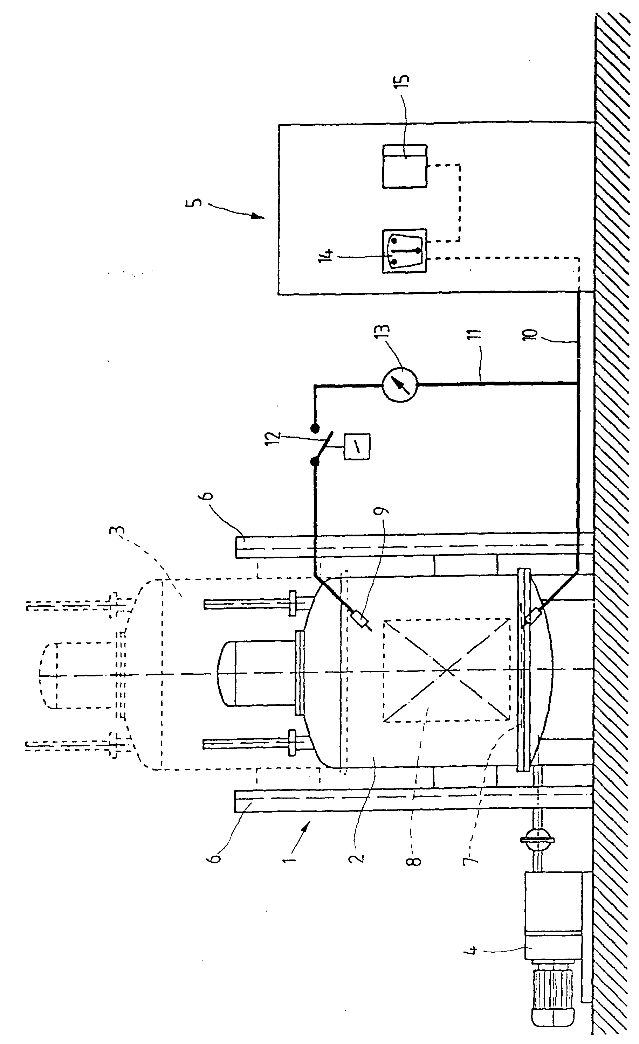

**Patentansprüche**

1. Verfahren zur Steuerung der elektrischen Stromdichte über einem Werkstück bei der Wärmebehandlung im Plasma unter Verwendung einer Hilfselektrode mit bekannter Oberfläche $F_{HE}$, **gekennzeichnet durch** die Verfahrensschritte:

   a) Erzeugen eines Plasmas mit einem neutralen Gas;

   b) Messen des Gesamtstroms $I_G$ im Ofen sowie des Stroms $I_{HE}$ durch die Hilfselektrode;

   c) Berechnen der Chargenoberfläche $F_{CH}$ nach der Gleichung

$$F_{CH} = \frac{I_G}{I_{HE}} \cdot F_{HE} - F_{HE}$$

   d) Abschalten der Hilfselektrode;

   e) Erzeugen eines stoffübertragenden Plasmas;

   f) Berechnen des einzustellenden Gesamtstroms $I_{Gsoll}$ zur Regelung des gewünschten Stromdichte-Sollwertes $J_{soll}$ nach der Gleichung:

$$I_{Gsoll} = F_{CH} \cdot J_{soll}$$

   und

   g) Messen des Gesamtstroms $I_G$ im Ofen und Einregeln von $I_G$ auf $I_{Gsoll}$.

2. Verfahren nach Anspruch 1, dadurch gekennzeichnet, daß als neutrales Gas Argon, Neon, Helium oder Wasserstoff verwendet wird.

**3.** Verfahren nach Anspruch 1, dadurch gekennzeichnet, daß zur Erzeugung des stoffübertragenden Plasmas ein nitrierendes, aufkohlendes oder borierendes Gas verwendet wird.

**4.** Vorrichtung zur Durchführung des Verfahrens nach einem der Ansprüche 1 bis 3 mit einem Ofen (1) mit einer Ofenkammer (2), in der ein Chargenträger (7) und eine Hilfselektrode (9) angeordnet sind und wobei der Chargenträger (7) und die Hilfselektrode (9) über eine Spannungsquelle mit der gleichen Polarität beaufschlagbar sind,
**dadurch gekennzeichnet,**
daß der Gesamtstrom $I_G$ im Ofen (1) über ein Strommeßgerät (14) meßbar ist und zwischen das Strommeßgerät (14) für den Gesamtstrom $I_G$ und die Hilfselektrode (9) ein Strommeßgerät (13) zum Messen des Stroms $I_{HE}$ über die Hilfselektrode (9) sowie ein Schalter (12) zum Abschalten der Hilfselektrode (9) geschaltet sind.

**5.** Vorrichtung nach Anspruch 4, dadurch gekennzeichnet, daß das Strommeßgerät (14) für den Gesamtstrom $I_G$ mit einem Regler (15) gekoppelt ist.

**Claims**

**1.** Method for controlling the electric current density above a workpiece during heat treatment in plasma using an auxiliary electrode of a known surface $F_{HE}$, characterised by
the method steps of:

a) Producing a plasma with a neutral gas;

b) Measuring the total current $I_G$ in the furnace and the current $I_{HE}$ through the auxiliary electrode;

c) Calculating the charge surface $F_{CH}$ according to the equation

$$F_{CH} = \frac{I_G}{I_{HE}} \cdot F_{HE} - F_{HE}$$

d) Turning off the auxiliary electrode;

e) Producing a material-transmitting plasma;

f) Calculating the total current $I_{Gsoll}$ which is to be set to regulate the desired current density set point $J_{soll}$ according to the equation:

$$I_{Gsoll} = F_{CH} \cdot J_{soll}$$

and

g) Measuring the total current $I_G$ in the furnace and setting $I_G$ to $I_{Gsoll}$.

**2.** Method according to Claim 1, characterised in that argon, neon, helium or hydrogen is used as the neutral gas.

**3.** Method according to Claim 1, characterised in that a nitriding, carburizing or boronizing gas is used to produce the material-transmitting plasma.

**4.** Apparatus for carrying out the method according to any one of Claims 1 to 3, comprising a furnace (1) with a furnace chamber (2), in which a charge carrier (7) and an auxiliary electrode (9) are disposed and wherein the charge carrier (7) and the auxiliary electrode (9) can be acted upon by a voltage source with the same polarity, characterised in that the total current $I_G$ in the furnace (1) can be measured by a current-measuring instrument (14), and a current-measuring instrument (13) for measuring the current $I_{HE}$ through the auxiliary electrode (9) and a switch (12) for turning off the auxiliary electrode (9) are connected between the current-measuring instrument (14) for the total current $I_G$ and the auxiliary electrode (9).

**5.** Apparatus according to Claim 4, characterised in that the current-measuring instrument (14) for the total current $I_G$ is coupled to a regulator (15).

**Revendications**

**1.** Procédé destiné à la commande de la densité du courant électrique au-dessus d'une pièce soumise à un traitement thermique au plasma, avec utilisation d'une électrode auxiliaire à surface $F_{HE}$ connue,
caractérisé par
les phases de procédé :

a) génération d'un plasma avec un gaz neutre ;
b) mesure du courant total $I_G$ dans le four, ainsi que du courant $I_{HE}$ par l'électrode auxiliaire ;
c) calcul de la surface de la charge $F_{CH}$ selon l'équation :

$$F_{CH} = \frac{I_G}{I_{HE}} \bullet F_{HE} - F_{HE}$$

d) coupure de l'électrode auxiliaire ;
e) génération d'un plasma transférant des matières ;
f) calcul du courant total $I_{Gsoll}$ à régler pour le réglage de la valeur de consigne $J_{soll}$ souhaitée de la densité du courant selon l'équation :

$$I_{Gsoll} = F_{CH} \cdot J_{soll}$$

et

g) mesure du courant total $I_G$ dans le four, et réglage de $I_G$ sur $I_{Gsoll}$.

2. Procédé selon la revendication 1, caractérisé en ce que de l'argon, du néon, de l'hélium ou de l'hydrogène est utilisé en tant que gaz neutre.

3. Procédé selon la revendication 1, caractérisé en ce qu'un gaz de nitruration, de carburation ou de boruration est utilisé pour la génération du plasma transférant des matières.

4. Dispositif destiné à la mise en oeuvre du procédé selon l'une quelconque des revendications 1 à 3, avec un four (1) comportant une chambre (2) de four dans laquelle sont disposés un support (7) de charge et une électrode auxiliaire (9), le support (7) de charge et l'électrode auxiliaire (9) pouvant être alimentés par la même polarité par l'intermédiaire d'une source de tension,
caractérisé en ce que
le courant total $I_G$ dans le four (1) peut être mesuré par l'intermédiaire d'un appareil de mesure de courant (14), et en ce qu'un appareil de mesure de courant (13) destiné à la mesure du courant $I_{HE}$ par l'intermédiaire de l'électrode auxiliaire (9), ainsi qu'un interrupteur (12) destiné à la coupure de l'électrode auxiliaire (9), sont branchés entre l'appareil de mesure de courant (14) pour le courant total $I_G$ et l'électrode auxiliaire (9).

5. Dispositif selon la revendication 4, caractérisé en ce que l'appareil de mesure de courant (14) pour le courant total $I_G$ est couplé avec un régulateur (15).